# EUROPÄISCHE PATENTSCHRIFT

(11) **EP 2 405 283 B1**
(45) Veröffentlichungstag und Bekanntmachung des Hinweises auf die Patenterteilung: **05.03.2014**
(21) Anmeldenummer: 10168569.1
(22) Anmeldetag: 06.07.2010
(51) Int. Cl.: G01S 17/02, G01J 1/44, G01S 17/93, G01S 7/497

(54) **Optoelektronische Messanordnung mit einer Kompensationslichtquelle**
Optoelectronic measuring assembly with a compensation light source
Agencement de mesure optoélectronique doté d'une source lumineuse de compensation

(43) Veröffentlichungstag der Anmeldung: 11.01.2012
(73) Patentinhaber: Mechaless Systems GmbH, 76646 Bruchsal (DE)
(72) Erfinder: Mayer, Bernd, 73479 Ellwangen (DE); Spiegel, Egbert, Dr., 45891 Gelsenkirchen (DE)
(74) Vertreter: Durm & Partner

(56) Entgegenhaltungen:
- DE-A1- 10 211 307
- DE-B3-102004 025 345

## Beschreibung

Die vorliegende Erfindung betrifft eine optoelektronische Messanordnung umfassend wenigstens zwei Sendelichtquellen, eine Kompensationslichtquelle, einen Empfänger zum Empfangen des von den Sendelichtquellen und der Kompensationslichtquelle ausgestrahlten Lichts und zur Umwandlung des empfangenen Lichtsignals in ein elektrisches Empfangssignal sowie eine Ansteuerund Auswerteeinheit. Durch die Erzeugung eines Kompensationsansteuersignals zur Ansteuerung der Kompensationslichtquelle wird eine Fremdlichtkompensation realisiert, so dass die zur Erkennung eines Gegenstandes durchgeführte Messung einer Änderung der Reflexion des Lichts an dem Gegenstand auch unabhängig von Fremdlicht erfolgen kann.

Optische Messanordnungen mit Fremdlichtkompensation sind beispielsweise aus der EP 0 706 648 B1 bekannt, die ein optisches System zur Detektion einer Änderung in der Reflexion an einem Gegenstand beschreibt. Bei diesem System sind Messungen bei vorherrschendem Fremdlicht möglich, ohne dass Änderungen des Fremdlichts oder Umgebungslichts Einfluss auf den Messwert haben. Ein solches System wird am Beispiel eines Scheibenwischersensors beschrieben, bei dem Regentropfen erkannt werden, die auf die Windschutzscheibe auftreffen. Mit derartigen Systemen lassen sich auch andere optische Messanordnungen zur Bewertung optischer Kopplungen realisieren. Beispiele hierfür sind Reflexionslichtschranken oder Durchlichtschranken.

Eine solche Messanordnung umfasst zwei Messstrecken, die jeweils aus einer Sendelichtquelle und einem gemeinsamen Empfänger gebildet werden. Eine der beiden zunächst gleichwertigen Sendelichtquellen wird nachfolgend auch als Kompensationslichtquelle bezeichnet. Jede Messstrecke weist eine optische Kopplung auf, die sich aus dem Verhältnis von empfangener zu ausgestrahlter Energie ergibt. Während die beiden Lichtquellen eine Strahlung, insbesondere Licht im sichtbaren oder unsichtbaren Bereich aussenden, detektiert der Empfänger das über die beiden Messstrecken gekoppelte Licht bzw. die Strahlung, die von Gegenständen oder anderen Oberflächen reflektiert bzw. von den jeweiligen Medien in den Messstrecken transmittiert werden. Durch den Vergleich der beiden Messstrecken kann ein Messsignal gewonnen werden, das unabhängig von den Einflüssen des Umgebungslichts und weiterer auf den Empfänger wirkender Störgrößen ist.

Die Messanordnung mit ihren zwei Sendelichtquellen und dem Empfänger wird durch ihre Ansteuer- und Auswerteeinheit so betrieben, dass die Sendelichtquellen mit der Frequenz eines gemeinsamen Taktgenerators abwechselnd Licht aussenden. Die somit modulierten Lichtanteile der beiden Sendelichtquellen sind dann, gewichtet durch die Kopplungsfaktoren der jeweiligen Messstrecken, im Empfangssignal enthalten. Die Auswerteeinheit demoduliert das Empfangssignal wieder synchron zum Taktgenerator in die beiden, den Messstrecken zugeordneten Signalanteile. Die Differenz beider Signalanteile wird nun mittels einer Kompensationsmessmethode zu Null kompensiert, indem die Ansteuersignale der Sendelichtquellen in ihrer Amplitude geregelt werden. Im kompensierten, d.h. ausgeregelten Zustand ist die empfangene Strahlungsmenge für beide Messstrecken gleich und der taktsynchrone Wechselanteil somit null. Das Verhältnis der Ansteuersignale beider Sendelichtquellen bildet das eigentliche Nutzsignal der Messanordnung.

Im Stand der Technik ist bekannt, im Falle von mehreren Messstrecken, also wenn deutlich mehr als zwei Messstrecken benötigt werden, für jede Messstrecke eine weitere Sendelichtquelle zu installieren. Dabei wird die Messanordnung in einem sequentiellen Multiplex-Betrieb ausgewertet, um nacheinander immer genau zwei Messstrecken gegeneinander auszuregeln. Dieses Verfahren führt jedoch mit steigender Anzahl von benötigten Messstrecken zu langen Verarbeitungszyklen und damit zu einem trägen Messsystem.

Das in der EP 0 706 648 B1 beschriebene System mit einer analogen Regelung ist in der EP 1 671 160 B1 weiterentwickelt und auf ein digitales System adaptiert, um eine vereinfachte technische Realisierung zu erzielen und gleichzeitig eine hohe Empfindlichkeit zu erreichen.

In der DE 103 00 223 B3 wird neben den Sendelichtquellen eine Kompensationslichtquelle verwendet. Es wird lediglich die Kompensationslichtquelle geregelt, während die jeweils verwendete Sendelichtquelle zur Überwachung einer optischen Messstrecke ungeregelt bleibt oder mit deutlich vereinfachten Mitteln angesteuert wird.

Die DE 10 2004 025 345 B3 offenbart eine Vorrichtung und ein Verfahren zum Erkennen eines Objekts an einer Schiebedachöffnung. Hierbei werden entlang der Umrandung der Schiebedachöffnung Lichtleiter eingesetzt. Das Verfahren beruht zwar auch auf einem kompensierenden Verfahren. Jedoch wird zur Erhöhung der Systemsicherheit ein Multiplexverfahren angewendet.

Aus dem bekannten Stand der Technik ergibt sich das Problem, dass bei Messanordnungen mit einer Vielzahl von optischen Messstrecken keine zeitgleiche Messung möglich ist. Aufgabe der vorliegenden Erfindung ist es deshalb, eine optische Messanordnung zu schaffen, die eine zeitgleiche Auswertung mehrerer Messstrecken bei hoher Empfindlichkeit ermöglicht und trotzdem möglichst kostengünstig ist und effizient arbeitet.

Gelöst wird die vorliegende Aufgabe mit einer optoelektronischen Messanordnung mit den Merkmalen des Anspruchs 1 sowie mit einem Verfahren mit den Merkmalen des Anspruchs 10.

Die erfindungsgemäße optoelektronische Messanordnung umfasst wenigstens zwei Sendelichtquellen, die Licht getaktet, phasenweise aussenden, eine Kompensationslichtquelle, die ebenfalls Licht abstrahlt, eine Empfangseinheit mit einem Empfänger, mindestens zwei Auswerteeinheiten, mindestens zwei Messstrecken, die jeweils eine Sendelichtquelle, eine Auswerteeinheit und einen Taktgenerator umfassen, und eine Ansteuereinheit.

Die optoelektronische Messanordnung hat also wenigstens drei Lichtquellen, wobei die Kompensationslichtquelle eine Lichtquelle mit angepasster optischer Kopplung zum Empfänger ist und unabhängig von den anderen Lichtquellen angesteuert wird. Der zwischen der Kompensationslichtquelle und dem Empfänger gebildete optische Pfad wird zumeist nicht zur Erkennung von Objekten verwendet. Dazu dienen die optischen Pfade, welche jeweils zwischen einer der verbleibenden wenigstens zwei Sendelichtquellen und dem Empfänger gebildet werden.

Der Empfänger dient zum Empfang des ausgestrahlten Lichts von den Sendelichtquellen und von der Kompensationslichtquelle. Aus dem empfangenen Lichtsignal wird im Empfänger ein elektrisches Empfangsignal erzeugt, das proportional zu dem Lichtsignal aller Sendelichtquellen ist. Insbesondere wird deren Wechsellichtanteil empfangen. Das ausgesendete Licht der Lichtquellen kann sichtbares Licht sein oder nicht sichtbares Licht, wie beispielsweise Infrarotlicht oder elektromagnetische Strahlung im nichtsichtbaren Frequenzbereich, wie etwa auch Radarstrahlung. Der Empfänger muss dann lediglich an die Lichtquellen bzw. deren Strahlung angepasst sein.

Daneben empfängt das Empfangselement Licht aus der Umgebung, das natürliches Umgebungslicht und/oder künstliches (man-made) Fremdlicht bzw. künstliches Umgebungslicht sein kann. Durch geeignete Filter wird das Signal auf die von den Sendelichtquellen genutzte Frequenzbandbreite begrenzt. Dieses Signal steht nach geeigneter Verstärkung am Ausgang des Empfängers als Empfangssignal zur Verfügung. Die wenigstens zwei Auswerteeinheiten erzeugen aus dem Empfangssignal jeweils ein Ansteuersignal für die jeweilige Sendelichtquelle und die vorzugsweise gemeinsam genutzte Kompensationslichtquelle.

Die erfindungsgemäße Messanordnung weist wenigstens zwei Messstrecken auf. Jede Messstrecke umfasst mindestens eine Sendelichtquelle mit einem sensorisch genutzten optischen Pfad zum Empfänger, eine Auswerteeinheit und einen Taktgenerator, der vorzugsweise in der Auswerteeinheit enthalten ist.

Der Empfänger und die Kompensationslichtquelle werden vorzugsweise zeitgleich für alle Messstrecken genutzt.

Der Taktgenerator erzeugt einen Takt zur Ansteuerung der jeweiligen Messstrecke. Somit wird jede Sendelichtquelle und jede Auswerteeinheit von einem eigenen Taktgenerator gespeist. Wichtig ist, dass die Sendelichtquelle und die Auswerteinheit einer Messstrecke von demselben Taktgenerator gespeist werden.

In der Auswerteeinheit der jeweiligen Messstrecke wird aus dem Empfangssignal, welches das abgestrahlte Licht aller Sendelichtquellen und der Kompensationslichtquelle umfasst, nur der zum eigenen Taktgenerator taktsynchrone Anteil demoduliert. Das Ansteuersignal beruht folglich nur noch auf dem Teil des Empfangssignals, der von der Sendelichtquelle der Messstrecke und der Kompensationslichtquelle erzeugt wurde.

Die Ansteuereinheit generiert aus den Ansteuersignalen aller Messstrecken ein Kompensationsansteuersignal. Sie wird deshalb auch als Kompensationsansteuereinheit bezeichnet. Die Ansteuersignale werden dabei von den Auswerteeinheiten der Messstrecken erzeugt. Das Kompensationsansteuersignal steuert und speist die Kompensationslichtquelle. Dabei kann optional ein Verstärker oder eine Stromtreibereinheit zwischen der Ansteuereinheit und der Kompensationslichtquelle angeordnet sein, um das Kompensationsansteuersignal zu verändern bzw. zu verstärken.

Durch die gemeinsame Verwendung des Empfängers und seiner Signalaufbereitung sowie der Kompensationslichtquelle können in der erfindungsgemäßen optoelektronischen Messanordnung mit geringem Aufwand zusätzliche optische Messstrecken hinzugefügt werden. Dazu muss lediglich eine neue Messstrecke, umfassend eine Sendelichtquelle, eine Auswerteeinheit und einen Taktgenerator, hinzugefügt werden. Diese Komponenten sind preisgünstig und lassen sich in eine bestehende Messanordnung einfach integrieren.

Im Stand der Technik wurde bisher davon ausgegangen, dass zur Kompensation der Fremdlichteinflüsse auf die Messstrecke eine direkte Zuordnung zwischen dem Kompensationssignal und dem Signal der Sendelichtquelle gegeben sein muss. Deshalb wurde bei einer Verwendung von mehreren Sendelichtquellen eine sequentielle Abarbeitung bzw. ein sequentielles Aussenden von Licht der einzelnen Sendelichtquellen vorgenommen. Dies führt jedoch zu langen Verarbeitungszyklen und zu trägen Messsystemen. Der Einsatz von hohen Umschaltfrequenzen zwischen den einzelnen Messstrecken als Abhilfe führt aber zu einem erhöhten Messrauschen, wodurch die Auswertung der Messstrecken gestört wird.

Selbst bei Verwendung weniger, hochempfindlicher Messstrecken z.B. für Gegenstandserkennungen auf Entfernungen im Meterbereich, bei denen nur geringe optische Kopplungen erreichbar sind, können die Messstrecken im sequentiellen Multiplexbetrieb mit einem Empfänger oft nicht schnell genug ausgewertet werden. Eine gleichwertige Anordnung mehrerer Empfänger für vollständig parallel arbeitende Messanordnungen ist hingegen meist durch die verwendeten Optiken nicht möglich.

Im Rahmen der Erfindung wurde nun erkannt, dass das Kompensationslichtsignal, welches von der Kompensationslichtquelle ausgesendet wird, auch zur gleichzeitigen Kompensation mehrerer, bevorzugt unterschiedlicher Lichtsignale von mehreren Sendelichtquellen verwendet werden kann. Da für jede optische Messstrecke, wie sie oben beschrieben ist, am Empfänger ein ausgeregeltes Nullsignal ohne taktsynchrone Wechsellichtanteile erzeugt wird, beeinflussen sich die einzelnen Messstrecken auch im zeitgleichen Betrieb untereinander nicht. Dabei ist es wichtig, dass für jede der Messstrecken die Modulationsfrequenz (die Frequenz des Taktgenerators) unterschiedlich ist und/oder ein anderes Modulationsschema verwendet wird. Bei der Verwendung einer Quadraturmodulation können je zwei Messstrecken auf nur einer (gleichen) Frequenz betrieben werden. Dazu werden die beiden Trägersignale phasenstarr mit einer Phasenverschiebung von 90 Grad betrieben und später durch eine kohärente Demodulation wieder getrennt. Somit findet eine bessere Ausnutzung der zur Verfügung stehenden Signalbandbreite des Empfängers statt. Bei der Verwendung unterschiedlicher Modulationsfrequenzen müssen sie, also die Taktfrequenzen der einzelnen Taktgeneratoren, beispielsweise ausreichend voneinander verschieden sein, damit in den einzelnen Auswerteeinheiten der unterschiedlichen Messstrecken der Messanordnung eine Trennung des entsprechenden Lichtsignals, das von der Sendelichtquelle der Sendestrecke herrührt, stattfinden kann. Aus dem elektrischen Empfangssignal wird der zu der jeweiligen Sendestrecke gehörende Signalanteil herausgefiltert, da bei einer Synchrondemodulation (auch kohärente Demodulation genannt) jeweils nur die Frequenz der jeweiligen Sendestrecke Beachtung findet. Dies wird dadurch erzielt, dass die Sendelichtquelle und die Auswerteeinheit von demselben Taktgenerator gesteuert und mit der gleichen Taktfrequenz gespeist werden.

Durch die entstehende Bandpasswirkung der in der Auswerteeinheit vorgenommenen Demodulation, die vorzugsweise nach dem Lock-in-Verfahren arbeitet, genügen bei einfacher Frequenzmodulation schon relativ geringe Frequenzabstände, beispielsweise von 0,1% bis 10% der Taktfrequenz. Die Taktfrequenzen der Taktgeneratoren zur Ansteuerung der einzelnen Sendelichtquellen müssen folglich so weit voneinander verschieden sein, dass sie bei der Demodulation wieder getrennt werden können. Vorzugsweise beträgt die Frequenzdifferenz zwischen zwei Taktfrequenzen wenigstens 1 kHz.

In einer bevorzugten Ausführungsform sind die von den Taktgeneratoren erzeugten Taktfrequenzen für die Ansteuerung der Sendelichtquellen wenigstens 20 kHz. Die Speisefrequenz ist also wenigstens 20 kHz.

Es hat sich als vorteilhaft erwiesen, dass die Taktfrequenzen von je zwei Taktgeneratoren kein ganzzahliges Vielfaches voneinander darstellen. Hierdurch wird die Effektivität der gesamten Messanordnung deutlich verbessert.

In einer bevorzugten Ausführungsform ist die Ansteuereinheit zur Ansteuerung der Kompensationslichtquelle ein Additionsglied. Hierdurch ist ein einfacher und kostengünstiger Aufbau der Messanordnung möglich. In dem Additionsglied werden die invertierten Ansteuersignale der einzelnen Sendestrecken zusammengeführt und ein entsprechendes Kompensationsansteuersignal erzeugt.

Das Kompensationsansteuersignal weist dann die Frequenzanteile der Ansteuersignale der einzelnen Auswerteeinheiten auf. Selbstverständlich ist es möglich auch zwei oder mehrere Kompensationslichtquellen zu verwenden.

Die erfindungsgemäße optoelektronische Messanordnung hat den Vorteil, dass eine zeitgleiche Auswertung der einzelnen Messstrecken, d. h. der von den einzelnen Sendelichtquellen abgestrahlten Lichtsignale möglich ist. Die Anzahl der Sendelichtquellen kann somit bei gleicher Anzahl von Empfangseinheiten und gleicher Messwerterfassungsrate deutlich gesteigert werden. Beispielsweise lassen sich 10, 20 50, 70 oder 100 Sendelichtquellen einsetzen, wobei nur ein Empfänger verwendet wird. Auf diese Weise lassen sich beispielsweise Lichtbänder aufbauen, um z. B. eine Durchgangskontrolle durch Türen oder andere Öffnungen durchzuführen. Dabei können auf Strecken von mehreren Metern viele Sendelichtquellen nah beieinander positioniert werden, so dass ein engmaschiges Überwachungsraster gebildet werden kann.

Die Erfindung zeichnet sich dadurch aus, dass einige Ressourcen eines optischen Sensors gemeinsam genutzt werden. Zum einen muss nur eine Kompensationslichtquelle verwendet werden, um die ausgesandten Lichtsignale von einer Mehrzahl von Sendelichtquellen gleichzeitig zu kompensieren. Darüber hinaus können der Empfänger und ein optional eingesetzter Empfangsverstärker ebenfalls gemeinsam genutzt werden. Auch andere, einer Empfangseinheit zuordenbare Komponenten, wie z. B. Filter (Tiefpaß, Hochpaß, Bandpaß) können gemeinsam genutzt werden. Gerade der Empfänger mit seinem in der Regel vorhandenen Vorverstärker sind kostenintensive Komponenten.

Häufig können diese Komponenten auch auf Grund der schaltungstechnischen Anordnung und der örtlichen Gegebenheiten beim Einsatz von Messanordnungen oder Sensorsystemen nicht in beliebiger Anzahl positioniert und verbaut werden.

Durch die effiziente Nutzung einzelner (teurer) Komponenten entsteht somit eine kostengünstige Messanordnung. Zwar werden bei der erfindungsgemäßen Messanordnung die Auswerteeinheiten und die Taktgeneratoren mehrfach ausgeführt. Jede Sendestrecke hat eine eigene Auswerteeinheit und einen eigenen Taktgenerator. Dennoch lassen sich diese Komponenten preiswert in Form von elektronischen Bauteilen realisieren. Sie können beispielsweise in einem IC oder einem ASIC integriert werden, so dass die Vervielfachung dieser Komponenten zu keiner nennenswerten Kostenerhöhung führt.

Die vorliegende Erfindung erlaubt es also, trotz der Verwendung mehrerer Sendelichtquellen und der zeitgleichen Auswertung aller Sendelichtquellen durch die Verwendung eines Modulationsschemas (vorzugsweise einer Frequenzmodulation) ohne Verlust der Fremdlichtunabhängigkeit arbeiten zu können. Deshalb lassen sich solche Messanordnungen ohne großen Aufwand auch in Fabrikhallen oder in Räumen mit Tageslicht einsetzen. Eine Abschirmung der einzelnen Messstrecken oder Sendestrecken muss nicht vorgenommen werden.

Wird beispielsweise beim Aufbau sehr großer Lichtgitter, um einen größeren Bereich abzudecken, eine Vielzahl von Lichtquellen benötigt, können selbstverständlich auch mehrere Messanordnungen miteinander kombiniert werden. Die Messanordnungen können dann im Multiplexverfahren gemeinsam verarbeitet und ausgewertet werden. Häufig genügen zwei oder drei obenbeschriebener Messanordnungen, so dass nur zwei oder drei Eingangsgrößen im Multiplexverfahren verarbeitet werden müssen und somit die Reaktionszeit des Gesamtsystems ebenfalls sehr gering bleibt.

Das eingangs beschriebene Problem wird auch durch das erfindungsgemäße Verfahren gelöst, bei dem mittels einer optoelektronischen Messanordnung mit Fremdlichtkompensation mehrere optische Sendestrecken zeitgleich ausgewertet werden. Die verwendete Messanordnung umfasst dabei wenigstens zwei Sendelichtquellen, die zeitsequentiell getaktetes Licht phasenweise aussenden, eine Kompensationslichtquelle, die unabhängig von den Sendelichtquellen angesteuert wird und ein Kompensationslicht aussendet, und einen Empfänger zum Empfang des von den Sendelichtquellen und der Kompensationslichtquelle ausgestrahlten Lichts, insbesondere dessen Wechsellichtanteils. Der Empfänger empfängt daneben auch das in der Umgebung vorherrschende Fremdlicht und/oder Umgebungslicht.

Die Messanordnung schließt weiter wenigstens zwei Auswerteeinheiten ein, von denen jede einer Sendelichtquelle zugeordnet ist. Die Auswerteeinheiten dienen zur taktsynchronen Auswertung der Wechsellichtanteile der empfangenen, von den Sendelichtquellen und der Kompensationslichtquelle ausgesendeten Lichtsignalen. Aus dem empfangenen Lichtsignal wird in jeder Auswerteeinheit ein Ansteuersignal erzeugt. Die Ansteuereinheit der Messanordnung führt alle erzeugten Ansteuersignale der Auswerteeinheiten zu einem Kompensationssignal zusammen.

Das erfindungsgemäße Verfahren umfasst dabei die folgenden Schritte:
Empfangen eines Lichtsignals mit Wechsellichtanteil, welches Licht aus wenigstens zwei Sendelichtquellen und einer Kompensationslichtquelle umfasst. In einem nächsten Schritt wird der Wechsellichtanteil in ein elektrisches Empfangssignal umgewandelt. Das Empfangssignal wird den wenigstens zwei Auswerteeinheiten zugeführt. Vorzugsweise ist die Zuführung parallel und somit zeitgleich. In einem weiteren Schritt erfolgt eine taktsynchrone, frequenzselektive Auswertung des Empfangssignals in jeder der Auswerteeinheiten. Die Auswertung basiert auf der jeweiligen Modulationsfrequenz, die durch den zugeordneten Taktgenerator vorgegebenen ist. Die beiden Signalanteile der Sendelichtquelle (Inphase) und der Kompensationslichtquelle (Gegenphase) werden zunächst demoduliert. Ist das System ausgeregelt, so gibt es im Empfangssignal bezüglich dieser Modulationsfrequenz keine taktsynchronen Wechselanteile und folglich sind die beiden demodulierten Phasen gleich groß. Liegt jedoch keine ausgeregelte Sendestrecke vor, so ergibt sich eine Differenz zwischen den beiden demodulierten Signalanteilen. Diese Differenz wird anschließend von einem Regler zu null kompensiert, indem die Sendelichtquelle und die Kompensationslichtquelle über die entsprechenden Ansteuersignale der Auswerteeinheit so angesteuert werden, dass sich im Empfangssignal beide Anteile wieder genau auslöschen.

Ein weiterer Schritt umfasst das Zuführen des Ansteuersignals an die der Auswerteeinheit zugeordneten Sendelichtquelle, so dass die Sendelichtquelle mit der gleichen Frequenz gespeist wird, die auch der Auswerteeinheit zur Verarbeitung zur Verfügung steht. Das bzw. die Ansteuersignale werden invertiert und als invertiertes Ansteuersignal einer Ansteuereinheit zugeführt. In einem weiteren Schritt werden alle invertierten Ansteuersignale der Auswerteeinheiten zu einem Kompensationsansteuersignal zusammengeführt, das die Frequenzanteile aller Ansteuersignale umfasst. Bevorzugt erfolgt die Zusammenführung der invertierten Ansteuersignale mittels eines Additionsgliedes. Das Kompensationsansteuersignal wird der Kompensationslichtquelle zugeführt. Zum Speisen der Kompensationslichtquelle kann beispielsweise das Kompensationsansteuersignal mittels eines Stromtreibers oder eines Verstärkers verstärkt werden. Ein Stromtreiber oder Verstärker kann auch zur Verstärkung des Ansteuersignals bzw. Sendesignals zum Speisen der Sendelichtquellen eingesetzt werden.

Die Erfindung wird nachfolgend anhand von in den Figuren dargestellten besonderen Ausführungsformen näher erläutert. Die dort dargestellten Besonderheiten können einzeln oder in Kombination verwendet werden, um bevorzugte Ausgestaltungen der Erfindung zu schaffen. Die beschriebenen Ausführungen stellen keine Einschränkung der durch die Ansprüche in ihrer Allgemeinheit definierten Erfindung dar. Es zeigen:
- Figur 1: ein Prinzipschaltbild einer erfindungsgemäßen Schaltungsanordnung zur zeitgleichen Auswertung mehrerer optischer Messstrecken mit Fremdlichtkompensation;
- Figur 2: die Signalverläufe der Ansteuersignale der Lichtquellen;
- Figur 3: ein Anwendungsbeispiel der Messanordnung aus Figur 1 in Form eines Lichtvorhangs;
- Figur 4: ein weiteres Anwendungsbeispiel der Messanordnung als Hinderniserkennungseinheit.

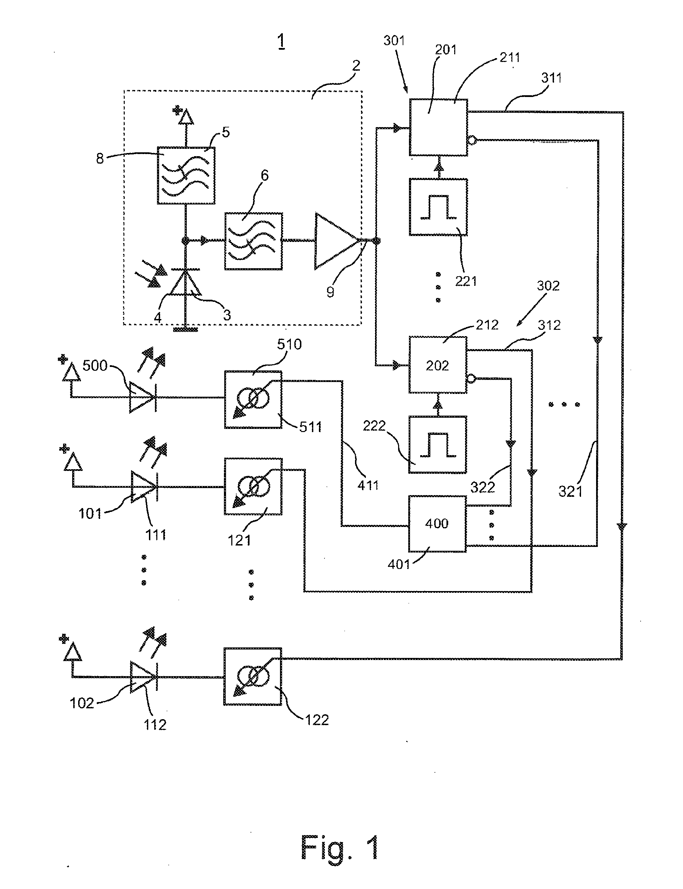

Figur 1 zeigt eine optoelektronische Messanordnung 1 zur zeitgleichen Auswertung mehrerer optischer Messstrecken mit Fremdlichtkompensation. Eine Empfangseinheit 2 umfasst einen Empfänger 3, der bevorzugt eine Photodiode 4 zum Empfang von Licht ist, eine Photostromkompensation 5, einen Hochpassfilter 6 und einen Vorverstärker 7. Die Photostromkompensation 5 kann beispielsweise ein Tiefpassfilter 8 sein. Mittels des Tiefpasses 8 werden niederfrequente Signalanteile, die in der Regel auf Fremdlicht, Störlicht oder Umgebungslicht beruhen, herausgefiltert und abgeleitet. Der Hochpassfilter 6 dagegen lässt nur recht hochfrequente Signale durch, und sperrt gleichzeitig niederfrequente Signale und Gleichtaktsignale. Der Hochpass 6 ist so dimensioniert, dass die Nutzsignale der optoelektronischen Messanordnung 1 durchgelassen werden. In dem anschließenden Vorverstärker 7 werden diese Signale verstärkt. In einer einfachen Variante der Messanordnung 1 umfasst die Empfangseinheit 2 lediglich den Empfänger 3, in dem das von der Photodiode 4 empfangene Licht in ein elektrisches Empfangssignal umgewandelt wird. Das empfangene Licht enthält Anteile des von Lichtquellen der Messanordnung 1 ausgesandten Lichts.

Zum Aussenden eines optischen Nutzsignals in Form von Licht umfasst die Messanordnung 1 eine Mehrzahl von Sendelichtquellen 101, 102, von denen zwei dargestellt sind. Sie sind vorzugsweise als lichtemittierende Dioden (LED) 111, 112 ausgebildet. Selbstverständlich sind auch andere Lichtquellen möglich. Die Gestaltung und Auswahl der Lichtquellen hängt vom Einsatz der Messanordnung 1 ab.

Das Signal zur Ansteuerung der Sendelichtquellen 101, 102 kann optional durch einen Verstärker verstärkt werden. Bevorzugt, wie in Figur 1 gezeigt, kann ein Stromtreiber 121, 122 in jedem Pfad zu der entsprechenden Sendelichtquelle 101, 102 angeordnet sein. Auf diese Weise lässt sich die Amplitude des Steuersignals für die Sendelichtquellen 101, 102 regeln.

Das von der Empfangseinheit 2 zur Verfügung gestellte elektrische Empfangssignal 9 wird parallel zu einer Mehrzahl von Auswerteeinheiten 201, 202 geführt. Die Auswerteeinheiten 201, 202 sind bevorzugt als Demodulator 211, 212 ausgebildet, um aus dem Empfangssignal 9 den Signalanteil für eine bestimmte, vorgegebene Frequenz herauszufiltern. Dazu werden die Demodulatoren 211, 212 jeweils von einem eigenen Taktgenerator 221, 222 angesteuert. Der Demodulator 211, 212 zerlegt das zur Frequenz des Taktgenerators 221, 222 taktsynchrone Wechselsignal aus dem Empfangssignal 9 in zwei Signalanteile.

Diese Signalanteile bilden den zum Taktgenerator 221, 222 gleichphasigen und den gegenphasigen Anteil. Die beiden Anteile dienen der eigentlichen Kompensation zu Null, welche vorzugsweise durch einen Regler erfolgt. Der Regler ist ebenfalls Teil der Auswerteeinheit 201, 202. Das Ausgangssignal des Reglers wird anschließend wieder mit der Frequenz des Taktgenerators 221, 222 moduliert und wird am Ausgang der Auswerteeinheit 201, 202 als Ansteuersignal 311, 312 bzw. als invertiertes Ansteuersignal 321, 322 zur Verfügung gestellt.

Die Auswerteeinheiten 201, 202 bilden gemeinsam mit den Taktgeneratoren 221, 222 und den Sendelichtquellen 101, 102 jeweils eine Sendestrecke 301, 302. Der Taktgenerator 221 der Sendestrecke 301 stellt zum einen den Takt für die Auswerteeinheit 201 als auch den Takt für die Sendelichtquelle 101 bzw. deren Ansteuerung zur Verfügung, so dass die Sendelichtquelle 101 zeitsequentiell getaktetes Licht phasenweise ausstrahlen kann.

Da die einzelnen Sendestrecken 301, 302 parallel geschaltet sind, liegt an den Eingängen der (zugehörigen) Auswerteeinheiten 201, 202 das Empfangssignal 9 gleichzeitig an. Somit werden die Signalanteile, die von den parallel geschalteten Sendelichtquellen 101, 102 ausgesendet werden, zeitgleich verarbeitet.

Die Auswerteeinheiten 201, 202 der einzelnen Sendestrecken 301, 302 geben ein Ansteuersignal 311, 312 aus, das den Sendelichtquellen 101, 102 zugeführt wird. Gleichzeitig geben die Auswerteeinheiten 201, 202 ein invertiertes Ansteuersignal 321, 322 aus. Die Auswerteeinheiten 201, 202 umfassen dazu bevorzugt einen Inverter, um die Ansteuersignale 311, 312 zu invertieren. Die invertierten Ansteuersignale 321, 322 sind bevorzugt gegenüber den Ansteuersignalen 311, 312 um 180 Grad phasenverschoben. Die invertierten Ansteuersignale 321, 322 werden einer Ansteuereinheit 400 zugeführt, die vorzugsweise ein Additionsglied 401 ist. An den Eingängen der Ansteuereinheit 400 liegen die invertierten Ansteuersignale 321, 322 der jeweiligen Sendestrecken 301, 302 an. Die Ansteuereinheit 400 erzeugt aus den invertierten Ansteuersignalen 321, 322 ein Kompensationsansteuersignal 411. Vorzugsweise ist die Ansteuereinheit 400 ein Additionsglied. So entsteht das Kompensationsansteuersignal 411 aus der Summe der invertierten Ansteuersignale 321, 322.

Das Kompensationsansteuersignal 411 wird einer Kompensationslichtquelle 500 zugeführt. Sie ist unabhängig von den Sendelichtquellen 101, 102 und strahlt ebenfalls zeitsequentiell getaktetes Licht phasenweise aus, das die Frequenzanteile aller Taktgeneratoren 221, 222 umfasst. Vorzugsweise ist zwischen der Ansteuereinheit 400 und der Kompensationslichtquelle 500 eine Wandlereinheit 510 vorgesehen, mittels der das Kompensationsansteuersignal 411 der Kompensationslichtquelle 500 angepasst werden kann. Vorzugsweise ist die Wandlereinheit 510 ein spannungsgesteuerter Stromtreiber 511, mit dem das Stromsignal aus dem Kompensationsansteuersignal 411 erzeugt wird. Das Kompensationsansteuersignal 411 kann als Eingangsgröße für den Stromtreiber 511 dienen, um das Steuersignal für die Kompensationslichtquelle in der Amplitude zu verändern. Hierdurch ist es möglich, wie in dem bekannten Verfahren zur Fremdlichtkompensation, dass die am Empfänger 3 hervorgerufenen Amplituden der Signalanteile gleich groß sind und sich infolge der um 180 Grad phasenverschobenen Empfangssignalanteile (Stromanteil) im Empfangssignal gerade auslöschen.

Der Messanordnung 1 gemäß Figur 1 liegt also das Prinzip zugrunde, dass mehrere optische Messstrecken parallel geschaltet sind. Eine optische Messstrecke umfasst dabei eine Sendestrecke 301, 302, eine Kompensationslichtquelle 500 und eine Empfangseinheit 2. Die Empfangseinheit 2 und die Kompensationslichtquelle 500 werden gemeinsam von allen optischen Messstrecken genutzt. Dies hat den Vorteil, dass die Messanordnung 1 durch die gemeinsame Nutzung der Empfangseinheit insgesamt preisgünstig ist. Zudem lässt sich eine kompakte Baugröße realisieren, da die Auswerteeinheiten 201, 202 und die Taktgeneratoren 221, 222 sowie die Ansteuereinheit 400 und die Stromtreiber 121, 122, 511 wenigstens teilweise als integrierte Schaltung (IC oder ASIC) realisiert werden können. Diese Komponenten sind günstig und lassen sich kompakt aufbauen.

Die erfindungsgemäße Messanordnung 1 weist gegenüber dem Stand der Technik den Vorteil auf, dass eine Mindestdauer bei der Auswertung einzelner Messstrecken nicht abgewartet werden muss, bis die nächste Messstrecke aktiviert werden kann. Alle Messstrecken bzw. Sendestrecken arbeiten parallel.

Durch die Realisierung unterschiedlicher Sendestrecken 301, 302, die je einen eigenen Taktgenerator 221, 222 umfasst, sind die einzelnen Signale der Sendelichtquellen 101, 102 aus dem Empfangssignal 9, also aus dem Summensignal aller Sendelichtquellen, herauslesbar. Die parallele Anordnung und die Ausbildung mit mehreren parallel geschalteten Auswerteeinheiten 201, 202 führt zu einer echten Parallelverarbeitung, so dass eine absolut zeitgleiche Auswertung möglich ist. Darüber hinaus lassen sich mehrere solcher Messanordnungen auch in einen zusätzlichen Multiplex-Betrieb, also in eine sequentielle Verarbeitung einzelner Messanordnungen 1, integrieren. Auf diese Weise können m Messanordnungen im Multiplex-Betrieb arbeiten, wobei jede der Messanordnungen 1 jeweils n Messstrecken umfasst. Auf diese Weise können Lichtvorhänge realisiert werden, die auch größere räumliche Bereiche von mehreren Metern überwachen. Eine derartig kombinierte Anordnung weist gegenüber dem rein sequentiellen Betrieb einen deutlichen Zeitvorteil auf, da jeweils immer n Messstrecken parallel verarbeitet und ausgewertet werden. Typische Werte für n liegen im Bereich von 4 bis 16, bevorzugt zwischen 4 und 10. Mögliche Werte sind beispielsweise n = 4; 5; 8 oder 10.

In Figur 1 wird die Messanordnung 1 am Beispiel von zwei parallel arbeitenden Sendestrecken 301, 302 gezeigt und erläutert. Bevorzugt sind jedoch Ausführungsformen der Messanordnung 1, bei denen wenigstens fünf Sendestrecken 301 bis 305, besonders bevorzugt wenigstens 10 Sendestrecken realisiert sind. Die Obergrenze der parallel geschalteten Sendestrecken wird durch den vertretbaren Entwicklungsaufwand bezüglich der parallelisierten Auswerteschaltungen und durch den Bedarf der jeweiligen Anwendung vor allem bei fehlenden Alternativen bestimmt. Sie liegt beispielsweise bei ca. 100. Die Vorteile der Messanordnung 1 gegenüber herkömmlichen sequentiellen Systemen werden bei höherer Anzahl von Sendestrecken und bei wenigen Sendestrecken mit sinkendem Signal-Rausch-Verhältnis immer deutlicher.

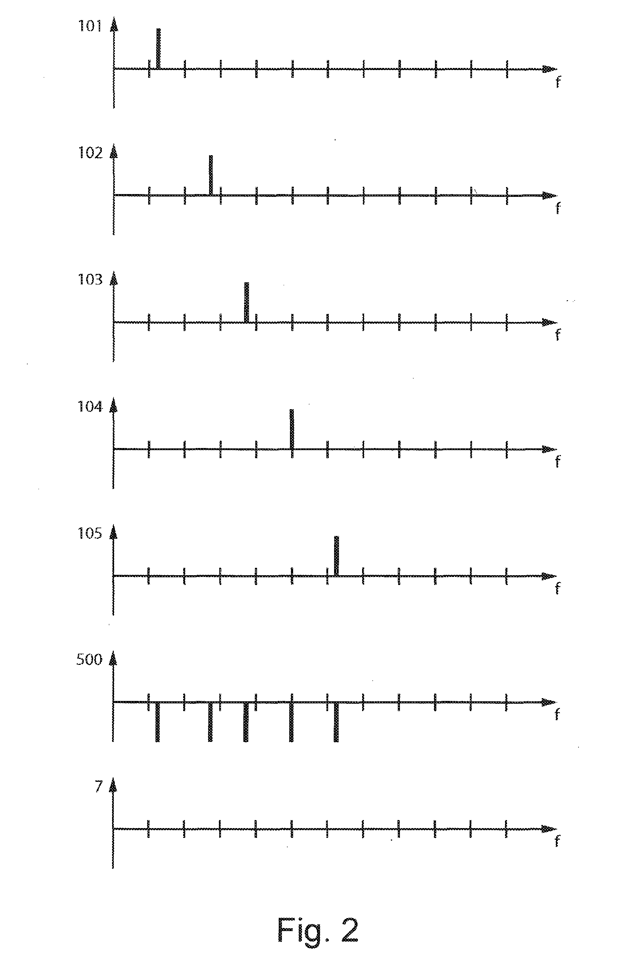

Figur 2 zeigt die Signalverläufe im Frequenzbereich der Speisesignale der Sendelichtquellen 101, 102 sowie des Speisesignals der Kompensationslichtquelle 500. In Figur 2 wird davon ausgegangen, dass fünf Sendestrecken parallel geschaltet sind.

Deutlich zu erkennen ist, dass die Speisesignale der einzelnen Sendelichtquellen 101 bis 105 jeweils nur eine Grundfrequenz aufweisen, während das Signal für die Kompensationslichtquelle 500 alle Grundfrequenzen der fünf Speisesignale der Sendelichtquellen zeigt.

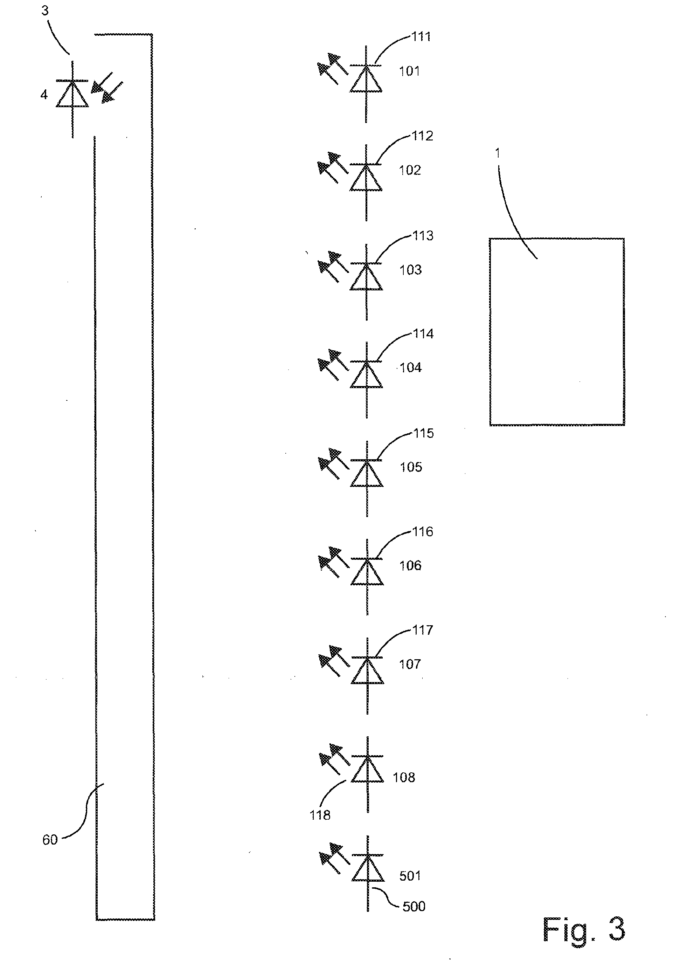

Figur 3 zeigt einen Lichtvorhang 20, der mittels einer Messanordnung 1 nach dem Prinzip gemäß Figur 1 aufgebaut ist. Dabei werden exemplarisch acht Sendelichtquellen 101 bis 108 eingesetzt, die als LEDs 111 bis 118 ausgebildet sind. Gegenüber diesen Lichtquellen befindet sich die Photodiode 4, die den Empfänger 3 bildet. Sie ist Teil der Empfangseinheit 2. Es ist möglich, die Photodiode 4 an einen Empfangslichtleiter 60 zu koppeln, der das von den LEDs 111, ..., 118 abgestrahlte Licht zur Photodiode 4 leitet. Zusätzlich zu den LEDs 101 bis 118 ist eine Kompensations-LED 501 positioniert, die die Kompensationslichtquelle 500 ist. Die Kompensations-LED 501 wird vorzugsweise so angeordnet, dass ihre optische Kopplung zur Photodiode 4 direkt wirkt und damit nicht das zu überwachende Raumvolumen überstreicht. Besonders bevorzugt wird die Kompensations-LED 501 direkt neben der Photodiode 4 angeordnet oder an einem Empfangslichtleiter 60 so angekoppelt, dass die ebenfalls angekoppelte Photodiode 4 geeignet bestrahlt wird.

Mit diesem Lichtvorhang 20 ist es möglich, auch mehrere kurzzeitig hintereinander an verschiedenen Stellen passierende im Verhältnis zum Gesamtlichtvorhang kleine Gegenstände zu detektieren, da alle acht gebildeten Messstrecken parallel verarbeitet und ausgewertet werden.

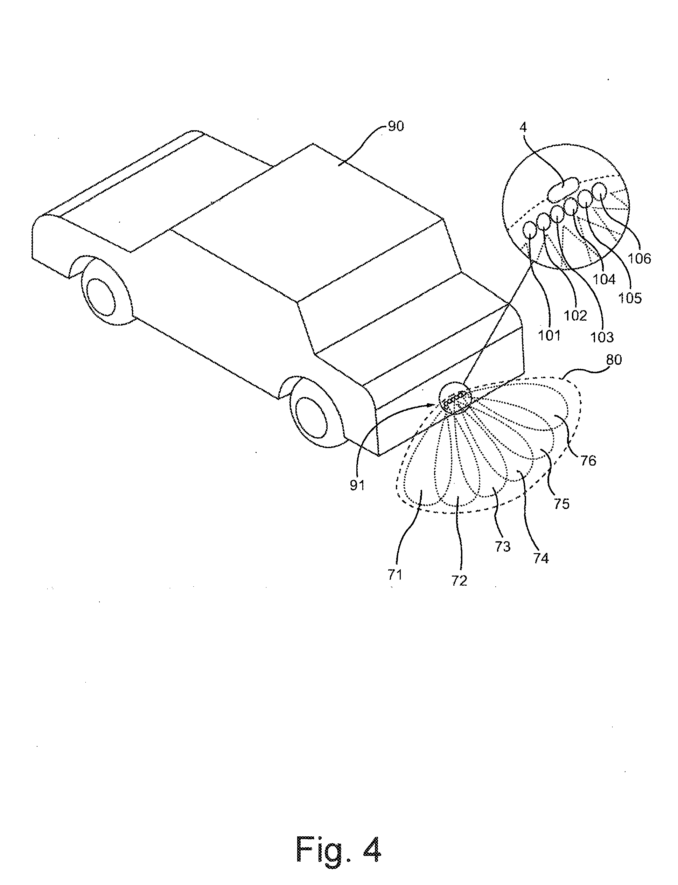

Figur 4 zeigt ein Fahrzeug 90 mit einer Hinderniserkennungseinheit 91, die aus der erfindungsgemäßen optoelektronischen Messanordnung gebildet wird. Im Bereich der Stoßstange des Fahrzeugs 90 sind eine Photodiode 4 und darunter sechs Sendelichtquellen 101, ... , 106 angeordnet, die die Hinderniserkennungseinheit 91 bilden. Die ebenfalls vorhandene Kompensationslichtquelle 500 ist in der Figur 4 nicht gezeigt, da sie unter der Abdeckung in der Photodiode 4, die Teil der ebenfalls nicht gezeigten Empfangseinheit 2 ist, angeordnet ist.

Die Sendelichtquellen 101, ... , 106 strahlen jeweils einen Lichtkegel 71, 72, ... , 76 ab, die gemeinsam einen Gesamtlichtkegel 80 bilden. Dieser Lichtkegel 80 stellt auch gleichzeitig den Überwachungsbereich der Hinderniserkennungseinheit 91 dar. Es zeigt sich, dass durch geeignete Ausrichtung der insbesondere äußeren Lichtquellen 101 und 106 ein Bereich von nahezu 180 Grad hinter dem Fahrzeug beleuchtet werden kann. Auf diese Weise ist es möglich, mit nur einer sehr kompakten Messanordnung den gesamten Bereich hinter dem Fahrzeug zu detektieren.

Selbstverständlich können auch mehr als sechs Sendelichtquellen 101, 102, ... , 106 verwendet werden, um einen Bereich abzudecken, der keine Lücken zwischen den einzelnen Lichtkegeln 71, 72, ... , 76, gebildet werden.

Der kompakte Aufbau der Hinderniserkennungseinheit 91 hat den Vorteil, dass der Einbauraum im Fahrzeug 90 gering ist. Damit wird auch das optische Design des Fahrzeugs nicht gestört, insbesondere weil die Messanordnung auch unsichtbar hinter der Stoßstange montiert werden kann. Das Material der Stoßstange muss lediglich partiell oder komplett für die von den Lichtquellen 101, 102, ... , 106 abgestrahlte elektromagnetische Strahlung (z. B. Infrarotlichtstrahlung) durchlässig sein. Neben diesen Vorteilen der Optik und dem geringen Preis der Hinderniserkennungseinheit 91 bietet sie eine sehr gute Auflösung nicht nur bei größerem Abstand im 1-Meter- oder 2-Meterbereich sondern auch im Nahbereich aufweist. Darüber hinaus wird durch die zeitgleiche Verarbeitung aller Sendestrecken eine schnelle Reaktionszeit und somit ein zuverlässig arbeitendes System erreicht.

## Patentansprüche

1. Optoelektronische Messanordnung umfassend
- wenigstens zwei Sendelichtquellen (101,102), die Licht zeitsequentiell getaktet, phasenweise aussenden,
- eine Kompensationslichtquelle (500), die Licht abstrahlt,
- eine Empfangseinheit (2) mit einem Empfänger (3) zum Empfang des von den Sendelichtquellen (101, 102) und der Kompensationslichtquelle (500) abgestrahlten Lichts, insbesondere deren taktsynchronen Wechsellichtanteil, und zu dessen Umwandlung in ein elektrisches Empfangssignal (9),
**gekennzeichnet durch**
- wenigstens zwei Auswerteeinheiten (201, 202) zur Auswertung des Empfangssignals (9) und zur Erzeugung je eines Ansteuersignals (311, 312), von denen jede mindestens einer Sendelichtquelle (101, 102) zugeordnet ist,
- wenigstens zwei Sendestrecken (301, 302), die jeweils mindestens eine Sendelichtquelle (101, 102), eine Auswerteeinheit (201, 202) und einen Taktgenerator (221, 222) umfassen, wobei der Taktgenerator (221, 222) den Takt für die Auswerteeinheit (201, 202) der Sendestrecke (301, 302) erzeugt,
- eine Ansteuereinheit (400), die aus den von den wenigstens zwei Auswerteeinheiten (201, 202) erzeugten wenigstens zwei Ansteuersignalen (321, 322) ein Kompensationsansteuersignal (411) generiert, mit dem die Kompensationslichtquelle (500) angesteuert und gespeist wird,
wobei die Auswerteeinheit (201, 202) einer Sendestrecke (301, 302) aus dem Empfangssignal (9) ein taktsynchrones Ansteuersignal (311, 312) für die Sendelichtquelle (101, 102) der Sendestrecke (301, 302) erzeugt.

2. Optoelektronische Messanordnung nach Anspruch 1, **dadurch gekennzeichnet, dass** die Auswerteeinheit (201, 202) einer Sendestrecke (301, 302) aus dem Empfangssignal (9) ein taktsynchrones Ansteuersignal (321, 322) zur Kompensation der zum Takt (221, 222) synchronen Wechsellichtanteile im Empfangssignal (09) erzeugt.

3. Optoelektronische Messanordnung nach Anspruch 1 oder 2, **dadurch gekennzeichnet, dass** die Ansteuereinheit (400) ein Additionsglied (401) umfasst.

4. Optoelektronische Messanordnung nach einem der vorhergehenden Ansprüche, **dadurch gekennzeichnet, dass** das Kompensationsansteuersignal (411) die Frequenzanteile der Ansteuersignale (321, 322) der wenigstens zwei Auswerteeinheiten (201, 202) aufweist.

5. Optoelektronische Messanordnung nach einem der vorhergehenden Ansprüche, **dadurch gekennzeichnet, dass** die Auswerteeinheiten (201, 202) die zugehörigen Sendelichtquellen (101, 102) taktsynchron steuern.

6. Optoelektronische Messanordnung nach einem der vorhergehenden Ansprüche, **dadurch gekennzeichnet, dass** die Taktfrequenzen zur Ansteuerung der Sendelichtquellen (101, 102) voneinander verschieden sind.

7. Optoelektronische Messanordnung nach Anspruch 6, **dadurch gekennzeichnet, dass** die Frequenzdifferenz zwischen zwei Taktfrequenzen wenigstens 1 kHz beträgt, bevorzugt wenigstens 2 kHz und/oder höchstens 10 kHz beträgt.

8. Optoelektronische Messanordnung nach einem der vorhergehenden Ansprüche, **dadurch gekennzeichnet, dass** die Taktfrequenzen für die Ansteuerung der Sendelichtquellen (101, 102) wenigstens 1 kHz, bevorzugt wenigstens 10 kHz, besonders bevorzugt wenigstens 100 kHz betragen.

9. Optoelektronische Messanordnung nach einem der vorhergehenden Ansprüche, **dadurch gekennzeichnet, dass** das Kompensationsansteuersignal (411) die um 180° phasenverschobenen Ansteuersignale (311, 312) der Auswerteeinheiten (201, 202) aufweist.

10. Verfahren zur zeitgleichen Auswertung mehrerer optischer Sendestrecken (301, 302) mittels einer optoelektronischen Messanordnung (1) nach Anspruch 1 umfassend die folgenden Schritte:
- Empfangen eines Lichtsignals mit Wechsellichtanteil,
- Umwandlung des Wechsellichtanteils in ein elektrisches Empfangssignal (9),
- Zuführung des elektrischen Empfangsignals (9) zu den wenigstens zwei Auswerteeinheiten (201, 202),
- Taktsynchrone, frequenzselektive Auswertung des Empfangssignals (9) und Erzeugung eines Ansteuersignals (311, 312) mit einer vorgegebenen Frequenz,
- Zuführung des Ansteuersignals (311, 312) an die der Auswerteeinheit (201, 202) zugeordneten Sendelichtquelle (101, 102),
- Invertieren des Ansteuersignals (311, 312) und Zuführen des invertierten Ansteuersignals (321, 322) an eine Ansteuereinheit (400),
- Zusammenführung aller invertierten Ansteuersignale (321, 322) der Auswerteeinheiten (201, 202) zu einem Kompensationsansteuersignal (411), das die Frequenzanteile aller Ansteuersignale (311, 312) umfasst,
- Speisen der Kompensationslichtquelle (500) mit dem Kompensationsansteuersignal (411).

## Claims

1. An optoelectronic measuring arrangement comprising
- at least two transmission light sources (101, 102) that emit clocked, phased light,
- a compensation light source (500) that radiates light,
- a receiver unit (2) with a receiver (3) for receiving the light radiated by the transmission light sources (101, 102) and the compensation light source (500), particularly the clock-synchronous alternating light component thereof, and for converting the light into an electrical receiving signal (9),
**characterized in that**
- at least two evaluation units (201, 202) for evaluating the receiving signal (9) and for generating one control signal (311, 312) each, wherein each evaluation unit (201, 202) is assigned to at least one transmission light source (101, 102),
- at least two transmission paths (301, 302), each comprising a transmission light source (101, 102), an evaluation unit (201, 202) and a clock generator (221, 222), wherein the clock generator (221, 222) generates the clock for the evaluation unit (201, 202) of the transmission path (301, 302),
- a control unit (400) that generates a compensation control signal (411) from the at least two control signals (321, 322) generated by the at least two evaluation units (201, 202), the compensation light source (500) being controlled and supplied by the compensation control signal (411),
wherein the evaluation unit (201, 202) of a transmission path (301. 302) generates a clock-synchronous control signal (311, 312) for the transmission light source (101, 102) of the transmission path (301, 302) from the receiving signal (9).

2. The optoelectronic measuring arrangement according to claim 1, **characterized in that** the evaluation unit (201, 202) of a transmission path (301, 302) generates a clock-synchronous control signal (321, 322) from the receiving signal (9) to compensate the clock (221, 222) synchronous alternating light components in the receiving signal (9).

3. The optoelectronic measuring arrangement according to claim 1 or 2, **characterized in that** the control unit (400) comprises an adder (401).

4. The optoelectronic measuring arrangement according to any one of the preceding claims, **characterized in that** the compensation control signal (411) contains the frequency components of the control signals (321, 322) of the at least two evaluation units (201, 202).

5. The optoelectronic measuring arrangement according to any one of the preceding claims, **characterized in that** the evaluation units (201, 202) control the associated transmission light sources (101, 102) in clocksynchronous manner.

6. The optoelectronic measuring arrangement according to any one of the preceding claims, **characterized in that** the clock frequencies for controlling the transmission light sources (101, 102) differ from each other.

7. The optoelectronic measuring arrangement according to claim 6, **characterized in that** the frequency difference between two clock frequencies is at least 1 kHz, preferably at least 2 kHz and/or not more than 10 kHz.

8. The optoelectronic measuring arrangement according to any one of the preceding claims, **characterized in that** the clock frequencies for controlling the transmission light sources (101, 102) are at least 1 kHz, preferably at least 10 kHz, particularly preferably at least 100 kHz.

9. The optoelectronic measuring arrangement according to any one of the preceding claims, **characterized in that** the compensation control signal (411) includes the control signals (311, 312) of the evaluation units (201, 202), which are phase-shifted by 180°.

10. A method for simultaneous evaluation of a plurality of optical transmission paths (301, 302) using an optoelectronic measuring arrangement (1) according to claim 1
comprising the following steps:
- receiving a light signal with alternating light component,
- converting the alternating light component into an electrical receiving signal (9),
- feeding the electrical receiving signal (9) to the at least two evaluation units (201, 202),
- clock-synchronous, frequency-selective evaluation of the receiving signal (9) and generation of a control signal (311, 312) with a preset frequency,
- feeding the control signal (311, 312) to the transmission light source (101, 102) assigned to the evaluation unit (201, 202),
- inverting the control signal (311, 312) and feeding the inverted control signal (321, 322) to a control unit (400),
- merging all inverted control signals (321, 322) of the evaluation units (201, 202) to form a compensation control signal (411) that includes the frequency components of all control signals (311, 312),
- supplying the compensation light source (500) with the compensation control signal (411).

## Revendications

1. Agencement de mesure optoélectronique comprenant
- au moins deux sources lumineuses émettrices (101, 102) qui émettent de la lumière par phases, de manière synchronisée par séquence temporelle,
- une source lumineuse de compensation (500) qui émet de la lumière,
- une unité réceptrice (2) comprenant un récepteur (3) pour la réception de la lumière émise par les sources lumineuses émettrices (101, 102) et la source lumineuse de compensation (500), en particulier de la composante de lumière alternante synchronisée de celles-ci, et pour sa conversion en un signal de réception électrique (9),
**caractérisé par**
- au moins deux unités d'évaluation (201, 202) pour l'évaluation du signal de réception (9) et pour la production de respectivement un signal de commande (311, 312), chacune d'elles étant associée à au moins une source lumineuse émettrice (101, 102),
- au moins deux parcours d'émission (301, 302) qui comprennent chacun au moins une source lumineuse émettrice (101, 102), une unité d'évaluation (201, 202) et un générateur d'horloge (221, 222), le générateur d'horloge (221, 222) produisant la cadence d'horloge pour l'unité d'évaluation (201, 202) du parcours d'émission (301, 302),
- une unité de commande (400) qui génère, à partir des au moins deux signaux de commande (321, 322) produits par les au moins deux unités d'évaluation (201, 202), un signal de commande de compensation (411) au moyen duquel la source lumineuse de compensation (500) est commandée et alimentée,
l'unité d'évaluation (201, 202) d'un parcours d'émission (301, 302) produisant, à partir du signal de réception (9), un signal de commande synchronisé (311, 312) pour la source lumineuse émettrice (101, 102) du parcours d'émission (301, 302).

2. Agencement de mesure optoélectronique selon la revendication 1, **caractérisé en ce que** l'unité d'évaluation (201, 202) d'un parcours d'émission (301, 302) produit, à partir du signal de réception (9), un signal de commande synchronisé (321, 322) pour la compensation des composantes de lumière alternante synchrones à la cadence d'horloge (221, 222) dans le signal de réception (9).

3. Agencement de mesure optoélectronique selon la revendication 1 ou 2, **caractérisé en ce que** l'unité de commande (400) est un organe d'addition (401).

4. Agencement de mesure optoélectronique selon l'une des revendications précédentes, **caractérisé en ce que** le signal de commande de compensation (411) comporte les composantes de fréquence des signaux de commande (321, 322) des au moins deux unités d'évaluation (201, 202).

5. Agencement de mesure optoélectronique selon l'une des revendications précédentes, **caractérisé en ce que** les unités d'évaluation (201, 202) commandent les sources lumineuses émettrices associées (101, 102) de manière synchronisée.

6. Agencement de mesure optoélectronique selon l'une des revendications précédentes, **caractérisé en ce que** les fréquences d'horloge pour la commande des sources lumineuses émettrices (101, 102) sont différentes les unes des autres.

7. Agencement de mesure optoélectronique selon la revendication 6, **caractérisé en ce que** la différence de fréquence entre deux fréquences d'horloge est au moins de 1 kHz, de préférence au moins de 2 kHz et/ou au plus de 10 kHz.

8. Agencement de mesure optoélectronique selon l'une des revendications précédentes, **caractérisé en ce que** les fréquences d'horloge pour la commande des sources lumineuses émettrices (101, 102) sont au moins de 1 kHz, de préférence au moins de 10 kHz, de manière particulièrement préférée au moins de 100 kHz.

9. Agencement de mesure optoélectronique selon l'une des revendications précédentes, **caractérisé en ce que** le signal de commande de compensation (411) comporte les signaux de commande (311, 312) déphasés de 180° des unités d'évaluation (201, 202).

10. Procédé d'évaluation simultanée de plusieurs parcours d'émission optiques (301, 302) au moyen d'un agencement de mesure optoélectronique (1) selon la revendication 1, comprenant les étapes suivantes :
- réception d'un signal lumineux à composante de lumière alternante,
- conversion de la composante de lumière alternante en un signal de réception électrique (9),
- envoi du signal de réception électrique (9) vers les au moins deux unités d'évaluation (201, 202),
- dévaluation synchronisée et sélective en fréquence du signal de réception (9) et production d'un signal de commande (311, 312) à une fréquence prédéterminée,
- envoi du signal de commande (311, 312) vers la source lumineuse émettrice (101, 102) associée à l'unité d'évaluation (201, 202),
- inversion du signal de commande (311, 312) et envoi du signal de commande inversé (321, 322) vers une unité de commande (400),
- regroupement de tous les signaux de commande inversés (321, 322) des unités d'évaluation (201, 202) pour former un signal de commande de compensation (411) comprenant les composantes de fréquence de tous les signaux de commande (311, 312),
- alimentation de la source lumineuse de compensation (500) avec le signal de commande de compensation (411).
